# EUROPEAN PATENT SPECIFICATION

(11) **EP 3 287 479 B1**
(45) Date of publication and mention of the grant of the patent: **27.11.2019**
(21) Application number: 16783106.4
(22) Date of filing: 15.04.2016
(51) Int. Cl.: C08G 59/40, B32B 15/092, B32B 27/38, C08J 5/24, C08L 63/00, H05K 1/03

(54) **RESIN COMPOSITION, PREPREG, METAL FOIL-CLAD LAMINATE, RESIN SHEET AND PRINTED WIRING BOARD**
HARZZUSAMMENSETZUNG, PREPREG, METALLFOLIENKASCHIERTES LAMINAT, HARZFOLIE UND LEITERPLATTE
COMPOSITION DE RÉSINE, PRÉIMPRÉGNÉ, STRATIFIÉ REVÊTU D'UNE FEUILLE MÉTALLIQUE, FEUILLE DE RÉSINE ET CARTE DE CIRCUIT IMPRIMÉ

(30) Priority: 21.04.2015 JP 2015086409
(43) Date of publication of application: 28.02.2018
(73) Proprietor: Mitsubishi Gas Chemical Company, Inc., Tokyo 100-8324 (JP)
(72) Inventor: KOBAYASHI, Takashi, Tokyo 125-8601 (JP); TAKANO, Kentaro, Tokyo 125-8601 (JP)
(74) Representative: Hoffmann Eitle
(86) International application number: PCT/JP2016/062166
(87) International publication number: WO 2016/171085

(56) References cited:
- EP-A1- 2 774 938
- WO-A1-2007/007827
- WO-A1-2013/065694
- WO-A1-2014/203866
- JP-A- 2013 043 958
- JP-A- 2013 043 958
- JP-A- 2014 205 755

## Description

### Technical Field

The present invention relates to a resin composition, a prepreg using the same, a metal foil-clad laminate using the prepreg, a resin sheet, and a printed wiring board.

### Background Art

In recent years, higher integration and miniaturization of semiconductors widely used in electronic equipment, communication instruments, personal computers, and the like have accelerated increasingly. With this, various characteristics required of laminates for semiconductor packages used in printed wiring boards have become increasingly strict. Examples of the required characteristics include characteristics such as low water absorbency, moisture absorption heat resistance, flame retardancy, a low dielectric constant, a low dielectric loss tangent, a low thermal expansion coefficient, heat resistance, chemical resistance, and high plating peel strength. But, these required characteristics have not always been satisfied so far.

Conventionally, as resins for printed wiring boards having excellent heat resistance and electrical characteristics, cyanate compounds are known, and resin compositions using cyanate compounds in combination with epoxy resins and the like have been widely used for materials for highly functional printed wiring boards such as for semiconductor plastic packages, and the like in recent years. In addition, due to smaller size and higher density of multilayer printed wiring boards, thinning laminates used for multilayer printed wiring boards is actively studied, but the problem of an increase in the warpage of multilayer printed wiring boards occurs, and therefore high glass transition temperature is required of resin compositions that are materials of insulating layers.

### Citation List

### Patent Literature

Patent Literature 1: International Publication No. WO 2013/065694
Patent Literature 2: International Publication No. WO 2014/203866

### Summary of Invention

### Technical Problem

Resin compositions comprising a cyanate compound and an epoxy resin that have excellent characteristics such as adhesiveness, low water absorbency, moisture absorption heat resistance, and insulation reliability are proposed (for example, see Patent Literatures 1 and 2), but a characteristics improvement in glass transition temperature is still insufficient, and therefore a further improvement in glass transition temperature is required.

The present invention has been made in view of the above problem, and an object of the present invention is to provide a resin composition having high glass transition temperature, a prepreg using the same, a metal foil-clad laminate using the prepreg, a resin sheet, a printed wiring board, and the like.

### Solution to Problem

The present inventors have diligently studied the above problem and, as a result, found that the above problem can be solved by using a cyanate compound (A) and a predetermined epoxy resin (B) in combination, arriving at the present invention.

Specifically, the present invention is as follows.
[1] A resin composition comprising:
   a cyanate compound (A); and
   an epoxy resin (B) having a structural unit represented by the following formula (1) and a structural unit represented by the following formula (2). 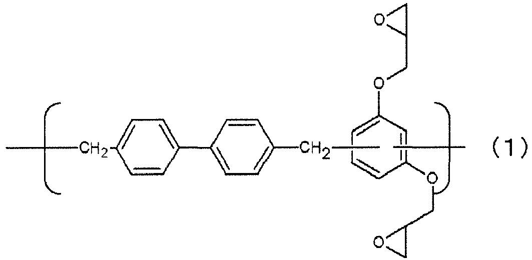 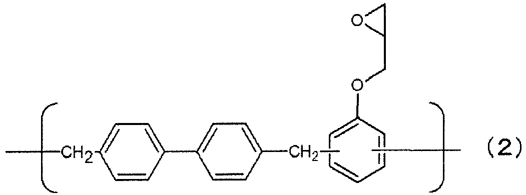
[2] The resin composition according to [1], wherein a content of the epoxy resin (B) is 1 to 90 parts by mass based on 100 parts by mass of resin solids in the resin composition.
[3] The resin composition according to [1] or [2], further comprising a filler (C).
[4] The resin composition according to any one of [1] to [3], further comprising any one or more selected from the group consisting of an epoxy resin other than the epoxy resin (B), a maleimide compound, a phenolic resin, an oxetane resin, a benzoxazine compound, and a compound having a polymerizable unsaturated group.
[5] The resin composition according to [3] or [4], wherein a content of the filler (C) is 50 to 1600 parts by mass based on 100 parts by mass of the resin solids in the resin composition.
[6] A prepreg comprising:
   a base material; and
   the resin composition according to any one of [1] to [5] with which the material is impregnated or coated.
[7] A metal foil-clad laminate comprising:
   at least one or more of the prepregs according to [6] stacked; and
   a metal foil disposed on one surface or both surfaces of the prepreg.
[8] A resin sheet comprising:
   a support; and
   the resin composition according to any one of [1] to [5] with which a surface of the support is coated and dried.
[9] A printed wiring board comprising:
   an insulating layer; and
   a conductor layer formed on a surface of the insulating layer, wherein
   the insulating layer comprises the resin composition according to any one of [1] to [5].

### Advantageous Effect of Invention

According to the present invention, a resin composition having high glass transition temperature, a prepreg using the same, a metal foil-clad laminate using the prepreg, a resin sheet, a printed wiring board, and the like can be provided, and their industrial practicality is extremely high.

### Description of Embodiment

A mode for carrying out the present invention (hereinafter referred to as "this embodiment") will be described in detail below, but the present invention is not limited to this.

### [Resin Composition]

A resin composition in this embodiment comprises a cyanate compound (A); and an epoxy resin (B) having a structural unit represented by the following formula (1) and a structural unit represented by the following formula (2).

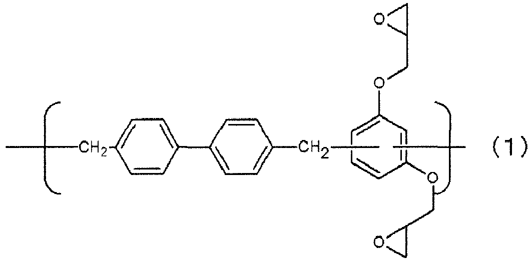

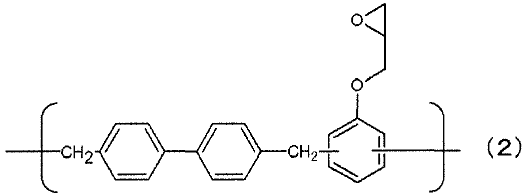

### [Cyanate Compound (A)]

The cyanate compound (A) used in this embodiment is not particularly limited as long as it is a resin having in the molecule an aromatic moiety substituted by at least one cyanato group (cyanate group). Examples of such a cyanate compound (A) include one represented by the following general formula (3). One cyanate compound (A) can be used alone, or two or more cyanate compounds (A) can be used in combination. 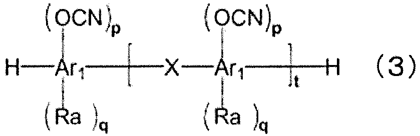 wherein Ar₁ each independently represents a phenylene group that may have a substituent, a naphthylene group that may have a substituent, or a biphenylene group that may have a substituent; Ra is each independently selected from any one of a hydrogen atom, an alkyl group having 1 to 6 carbon atoms that may have a substituent, an aryl group having 6 to 12 carbon atoms that may have a substituent, an alkoxyl group having 1 to 4 carbon atoms that may have a substituent, an aralkyl group that may have a substituent in which an alkyl group having 1 to 6 carbon atoms and an aryl group having 6 to 12 carbon atoms are bonded to each other, or an alkylaryl group that may have a substituent in which an alkyl group having 1 to 6 carbon atoms and an aryl group having 6 to 12 carbon atoms are bonded to each other; p represents the number of cyanato groups bonded to Ar₁ and is an integer of 1 to 3; q represents the number of Ra bonded to Ar₁ and is 4 - p when Ar₁ is a phenylene group, 6 - p when Ar₁ is a naphthylene group, and 8 - p when Ar₁ is a biphenylene group; t represents the average number of repetitions and is an integer of 0 to 50, and the cyanate compound may be a mixture of compounds having different t; and X is each independently selected from any one of a single bond, a divalent organic group having 1 to 50 carbon atoms (a hydrogen atom may be replaced by a heteroatom), a divalent organic group having 1 to 10 nitrogen atoms (-N-R-N-or the like), a carbonyl group (-CO-), a carboxy group (-C(=O)O-), a carbonyl dioxide group (-OC(=O)O-), a sulfonyl group (-SO₂-), or a divalent sulfur atom or a divalent oxygen atom.

The alkyl group for Ra in general formula (3) may have either a chain structure or a cyclic structure (cycloalkyl group or the like).

In addition, a hydrogen atom in the alkyl group and the aryl group for Ra in general formula (3) may be replaced by a halogen atom such as fluorine or chlorine, an alkoxyl group such as a methoxy group or a phenoxy group, a cyano group, or the like.

Specific examples of the alkyl group for Ra in general formula (3) include a methyl group, an ethyl group, a propyl group, an isopropyl group, a n-butyl group, an isobutyl group, a tert-butyl group, a n-pentyl group, a 1-ethylpropyl group, a 2,2-dimethylpropyl group, a cyclopentyl group, a hexyl group, a cyclohexyl group, and a trifluoromethyl group.

Specific examples of the aryl group for Ra in general formula (3) include a phenyl group, a xylyl group, a mesityl group, a naphthyl group, a phenoxyphenyl group, an ethylphenyl group, an o-, m-, or p-fluorophenyl group, a dichlorophenyl group, a dicyanophenyl group, a trifluorophenyl group, a methoxyphenyl group, and an o-, m-, or p-tolyl group. Further, examples of the alkoxyl group include a methoxy group, an ethoxy group, a propoxy group, an isopropoxy group, a n-butoxy group, an isobutoxy group, and a tert-butoxy group.

Specific examples of the divalent organic group for X in general formula (3) include a methylene group, an ethylene group, a trimethylene group, a cyclopentylene group, a cyclohexylene group, a trimethylcyclohexylene group, a biphenylylmethylene group, a dimethylmethylene-phenylene-dimethylmethylene group, a fluorenediyl group, and a phthalidediyl group. A hydrogen atom in the divalent organic group represented by X may be replaced by a halogen atom such as fluorine or chlorine, an alkoxyl group such as a methoxy group or a phenoxy group, a cyano group, or the like.

Examples of the divalent organic group having 1 to 10 nitrogen atoms for X in general formula (3) include an imino group and a polyimide group.

In addition, examples of X in general formula (3) include a group having a structure represented by the following general formula (4) or the following general formula (5). 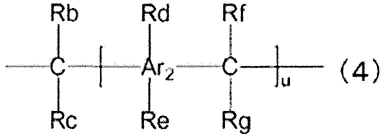 wherein Ar₂ is each independently selected from any one of a phenylene group, a naphthylene group, and a biphenylene group; Rb, Rc, Rf, and Rg are each independently selected from any one of a hydrogen atom, an alkyl group having 1 to 6 carbon atoms, an aryl group having 6 to 12 carbon atoms, a trifluoromethyl group, and an aryl group substituted by at least one phenolic hydroxy group; Rd and Re are each independently selected from any one of a hydrogen atom, an alkyl group having 1 to 6 carbon atoms, an aryl group having 6 to 12 carbon atoms, an alkoxyl group having 1 to 4 carbon atoms, and a hydroxy group; and u represents an integer of 0 to 5, and the cyanate compound may be a mixture of compounds having different u. 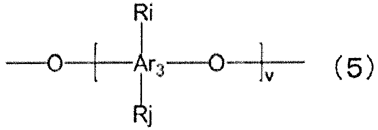 wherein Ar₃ is each independently selected from any one of a phenylene group, a naphthylene group, or a biphenylene group; Ri and Rj are each independently selected from any one of a hydrogen atom, an alkyl group having 1 to 6 carbon atoms, an aryl group having 6 to 12 carbon atoms, a benzyl group, an alkoxyl group having 1 to 4 carbon atoms, a hydroxy group, a trifluoromethyl group, and an aryl group substituted by at least one cyanato group; and v represents an integer of 0 to 5, and the cyanate compound may be a mixture of compounds having different v.

Further, examples of X in general formula (3) include divalent groups represented by the following formulas: 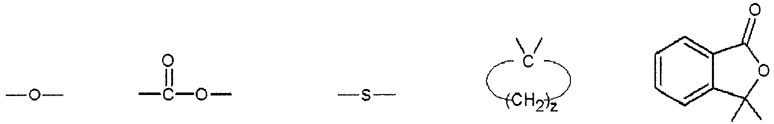 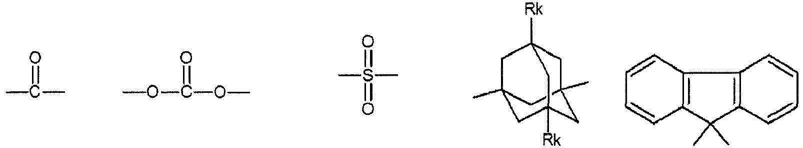 wherein z represents an integer of 4 to 7; and Rk each independently represents a hydrogen atom or an alkyl group having 1 to 6 carbon atoms.

Specific examples of Ar₂ in general formula (4) and Ar₃ in general formula (5) include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl group and the aryl group for Rb to Rf in general formula (4) and Ri and Rj in general formula (5) are similar to those described in general formula (3).

Specific examples of the cyanato-substituted aromatic compound represented by general formula (3) include cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4-, or 1-cyanato-3,5-dimethylbenzene, cyanatoethylbenzene, cyanatobutylbenzene, cyanatooctylbenzene, cyanatononylbenzene, 2-(4-cyanaphenyl)-2-phenylpropane (a cyanate of 4-α-cumylphenol), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (a cyanate of eugenol), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, methyl 4-cyanatobenzoate ester, phenyl 4-cyanatobenzoate ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-dimethylbenzene, 1,3-dicyanato-2,4,6-trimethylbenzene, 1,3-dicyanato-5-methylbenzene, 1-cyanato- or 2-cyanatonaphthalene, 1-cyanato4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6-, or 2,7-dicyanatonaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl) ether, bis(4-cyanatophenyl) sulfide, bis(4-cyanatophenyl) sulfone, 4-cyanatobenzoic acid-4-cyanatophenyl ester (4-cyanatophenyl-4-cyanatobenzoate), bis-(4-cyanatophenyl) carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (a cyanate of phenolphthalein), 3,3-bis(4-cyanato-3-methylphenyl)isobenzofuran-1(3H)-one (a cyanate of o-cresolphthalein), 9,9'-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cyanatobenzyl) isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, phenol novolac-based cyanate compounds, cresol novolac-based cyanate compounds, trisphenol novolac-based cyanate compounds, fluorene novolac-based cyanate compounds, phenol aralkyl-based cyanate compounds, cresol aralkyl-based cyanate compounds, naphthol aralkyl-based cyanate compounds, biphenyl aralkyl-based cyanate compounds, phenol-modified xylene formaldehyde-based cyanate compounds, modified naphthalene formaldehyde-based cyanate compounds, phenol-modified dicyclopentadiene-based cyanate compounds, and cyanate compounds of phenolic resins having a polynaphthylene ether structure but are not particularly limited. One of these cyanate compounds can be used, or two or more of these cyanate compounds can be mixed and used.

Examples of the phenol novolac-based cyanate compounds and the cresol novolac-based cyanate compounds include those obtained by cyanation of phenol novolac resins and cresol novolac resins by a known method. Examples of the phenol novolac resins and the cresol novolac resins include those obtained by reacting a phenol, an alkyl-substituted phenol, or a halogen-substituted phenol and a formaldehyde compound such as formalin or paraformaldehyde in an acidic solution by a known method.

Examples of the trisphenol novolac-based cyanate compounds include those obtained by cyanation of trisphenol novolac resins by a known method. Examples of the trisphenol novolac resins include those obtained by reacting hydroxybenzaldehyde and a phenol in the presence of an acidic catalyst.

Examples of the fluorene novolac-based cyanate compounds include those obtained by cyanation of fluorene novolac resins by a known method. Examples of the fluorene novolac resins include those obtained by reacting a fluorenone compound and a 9,9-bis(hydroxyaryl)fluorene in the presence of an acidic catalyst.

Examples of the phenol aralkyl-based cyanate compounds, the cresol aralkyl-based cyanate compounds, the naphthol aralkyl-based cyanate compounds, and the biphenyl aralkyl-based cyanate compounds include those obtained by cyanation of phenol aralkyl resins, cresol aralkyl resins, naphthol aralkyl resins, and biphenyl aralkyl resins by a known method. Examples of the phenol aralkyl resins, the cresol aralkyl resins, the naphthol aralkyl resins, and the biphenyl aralkyl resins include those obtained by reacting a bishalogenomethyl compound as represented by Ar₂-(CH₂Y)₂ and a phenol compound with an acidic catalyst or without a catalyst by a known method, those obtained by reacting a bis(alkoxymethyl) compound as represented by Ar₂-(CH₂OR)₂ or a bis(hydroxymethyl) compound as represented by Ar₂-(CH₂OH)₂ and a phenol compound in the presence of an acidic catalyst by a known method, or those obtained by polycondensing an aromatic aldehyde compound, an aralkyl compound, and a phenol compound by a known method.

Examples of the phenol-modified xylene formaldehyde-based cyanate compounds include those obtained by cyanation of phenol-modified xylene formaldehyde resins by a known method. Examples of the phenol-modified xylene formaldehyde resins include those obtained by reacting a xylene formaldehyde resin and a phenol compound in the presence of an acidic catalyst by a known method.

Examples of the modified naphthalene formaldehyde-based cyanate compounds include those obtained by cyanation of modified naphthalene formaldehyde resins by a known method. Examples of the modified naphthalene formaldehyde resins include those obtained by reacting a naphthalene formaldehyde resin and a hydroxy-substituted aromatic compound in the presence of an acidic catalyst by a known method.

Examples of the phenol-modified dicyclopentadiene-based cyanate compounds, and the cyanate compounds of phenolic resins having a polynaphthylene ether structure include those obtained by cyanation of phenol-modified dicyclopentadiene resins, and phenolic resins having a polynaphthylene ether structure by a known method. Examples of the phenol-modified dicyclopentadiene resins, and the phenolic resins having a polynaphthylene ether structure include those obtained by subjecting a polyvalent hydroxynaphthalene compound having two or more phenolic hydroxy groups in one molecule to dehydration condensation in the presence of a basic catalyst by a known method.

Among these, phenol novolac-based cyanate compounds, naphthol aralkyl-based cyanate compounds, biphenyl aralkyl-based cyanate compounds, naphthylene ether-based cyanate compounds, xylene resin-based cyanate compounds, and adamantane skeleton-based cyanate compounds are preferred, and naphthol aralkyl-based cyanate compounds are particularly preferred. Resin cured products using such cyanate compounds tend to have characteristics excellent in high glass transition temperature, low thermal expansion properties, plating adhesiveness, and the like.

The content of the cyanate compound (A) can be appropriately set according to the desired characteristics and is not particularly limited but is preferably 1 to 90 parts by mass, more preferably 20 to 75 parts by mass, and further preferably 40 to 60 parts by mass based on 100 parts by mass of resin solids in the resin composition. When the content of the cyanate compound (A) is in the above range, the glass transition temperature tends to improve more. In this embodiment, the "resin solids in the resin composition" refers to components in the resin composition excluding a solvent and a filler (C) unless otherwise noted, and "100 parts by mass of resin solids" refers to the total of the components in the resin composition excluding the solvent and the filler (C) being 100 parts by mass.

### [Epoxy Resin (B)]

The epoxy resin (B) used in this embodiment has a structural unit represented by the following formula (1) and a structural unit represented by the following formula (2). By using the epoxy resin (B) having both the structural unit represented by the following formula (1) and the structural unit represented by the following formula (2), the glass transition temperature improves more. One epoxy resin (B) can be used alone, or two or more epoxy resins (B) can be used in combination.

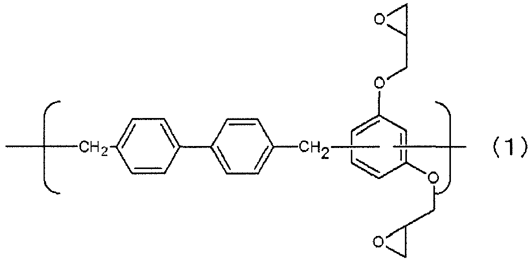

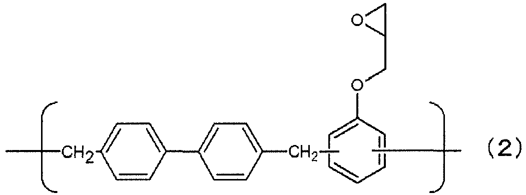

The molar ratio of the structural unit represented by formula (2) to 10 mol of the structural unit represented by formula (1) is preferably in the range of 0.1 to 5, more preferably in the range of 0.5 to 4, and further preferably in the range of 1 to 3. When the molar ratio of the structural unit represented by formula (2) to 10 mol of the structural unit represented by formula (1) is in the above range, the glass transition temperature tends to improve more.

As the above epoxy resin (B), commercial ones may be used, and, for example, NC-3500 manufactured by Nippon Kayaku Co., Ltd. can be preferably used.

The content of the epoxy resin (B) can be appropriately set according to the desired characteristics and is not particularly limited but is preferably 1 to 90 parts by mass, more preferably 20 to 75 parts by mass, and further preferably 40 to 60 parts by mass based on 100 parts by mass of the resin solids in the resin composition. When the content of the epoxy resin (B) is in the above range, a resin composition having excellent glass transition temperature tends to be obtained.

### [Filler (C)]

The resin composition in this embodiment may further contain the filler (C). As the filler (C), known ones can be appropriately used, and the type of the filler (C) is not particularly limited. Inorganic fillers or organic fillers generally used in the industry can be preferably used.

The inorganic fillers are not particularly limited. Examples thereof include silicas such as natural silica, fused silica, synthetic silica, amorphous silica, AEROSIL, white carbon, and hollow silica; oxides such as titanium white, alumina, zinc oxide, magnesium oxide, boehmite, and zirconium oxide; nitrides such as boron nitride, aggregated boron nitride, silicon nitride, and aluminum nitride; sulfates such as barium sulfate; hydroxides such as aluminum hydroxide, heat-treated products of aluminum hydroxide (products obtained by heat-treating aluminum hydroxide to decrease some of the water of crystallization), and magnesium hydroxide; molybdenum compounds such as molybdenum oxide and zinc molybdate; borates such as zinc borate; stannates such as zinc stannate; and silicates such as clay, kaolin, talc, calcined clay, calcined kaolin, calcined talc, mica, E-glass, A-glass, NE-glass, C-glass, L-glass, D-glass, S-glass, M-glass G20, glass short fibers (including fine powders of glass such as E glass, T glass, D glass, S glass, and Q glass), hollow glass, and spherical glass.

In addition, the organic fillers are not particularly limited. Examples thereof include rubber powders such as styrene-based rubber powders, butadiene-based rubber powders, and acrylic rubber powders; core-shell-based rubber powders; silicone resin powders; silicone rubber powders; and silicone composite powders. One of these fillers can be used alone, or two or more of these fillers can be used in combination.

By using these fillers (C), the characteristics, such as thermal expansion characteristics, dimensional stability, and flame retardancy, of the resin composition tend to improve.

The content of the filler (C) can be appropriately set according to the desired characteristics and is not particularly limited but is preferably 50 to 1600 parts by mass, more preferably 50 to 1000 parts by mass, further preferably 50 to 500 parts by mass, and particularly preferably 50 to 250 parts by mass based on 100 parts by mass of the resin solids in the resin composition. When the content of the filler (C) is in the above range, the moldability of the resin composition tends to improve more.

Here, when the filler (C) is used, a silane coupling agent and a wetting and dispersing agent are preferably used in combination. As the silane coupling agent, those generally used for surface treatment of inorganic matter can be preferably used, and the type of the silane coupling agent is not particularly limited. Specific examples include aminosilane-based compounds such as γ-aminopropyltriethoxysilane and N-β-(aminoethyl)-γ-aminopropyltrimethoxysilane; epoxysilane-based compounds such as γ-glycidoxypropyltrimethoxysilane and β-(3,4-epoxycyclohexyl)ethyltrimethoxysilane; vinylsilane-based compounds such as γ-methacryloxypropyltrimethoxysilane and vinyl-tri(β-methoxyethoxy)silane; cationic silane-based compounds such as N-β-(N-vinylbenzylaminoethyl)-γ-aminopropyltrimethoxysilane hydrochloride; and phenylsilane-based compounds. One of these silane coupling agents can be used alone, or two or more of these silane coupling agents can be used in combination.

In addition, as the wetting and dispersing agent, those generally used for paints can be preferably used, and the type of the wetting and dispersing agent is not particularly limited. Preferably, copolymer-based wetting and dispersing agents are used. Specific examples thereof include Disperbyk-110, 111, 161, and 180, BYK-W996, BYK-W9010, BYK-W903, and BYK-W940 manufactured by BYK Japan KK. One of these wetting and dispersing agents can be used alone, or two or more of these wetting and dispersing agents can be used in combination.

### [Other Components]

Further, the resin composition in this embodiment may contain other components as needed. The other components are not particularly limited. Examples thereof include any one or more selected from the group consisting of an epoxy resin other than the above epoxy resin (B) (hereinafter referred to as "another epoxy resin"), a maleimide compound, a phenolic resin, an oxetane resin, a benzoxazine compound, and a compound having a polymerizable unsaturated group. By using such other components, the desired characteristics, such as flame retardancy and low dielectric properties, of a cured product obtained by curing the resin composition can be improved.

As the another epoxy resin, known ones can be appropriately used as long as they are epoxy resins that do not have the structural units represented by formula (1) and formula (2) and that have two or more epoxy groups in one molecule. The type of the another epoxy resin is not particularly limited. Specific examples include bisphenol A-based epoxy resins, bisphenol E-based epoxy resins, bisphenol F-based epoxy resins, bisphenol S-based epoxy resins, phenol novolac-based epoxy resins, bisphenol A novolac-based epoxy resins, glycidyl ester-based epoxy resins, aralkyl novolac-based epoxy resins, biphenyl aralkyl-based epoxy resins, naphthylene ether-based epoxy resins, cresol novolac-based epoxy resins, polyfunctional phenol-based epoxy resins, naphthalene-based epoxy resins, anthracene-based epoxy resins, naphthalene skeleton-modified novolac-based epoxy resins, phenol aralkyl-based epoxy resins, naphthol aralkyl-based epoxy resins, dicyclopentadiene-based epoxy resins, biphenyl-based epoxy resins, alicyclic epoxy resins, polyol-based epoxy resins, phosphorus-containing epoxy resins, glycidyl amines, glycidyl esters, compounds obtained by epoxidizing double bonds of butadiene and the like, and compounds obtained by reaction of hydroxyl group-containing silicone resins and epichlorohydrin. Among these epoxy resins, biphenyl aralkyl-based epoxy resins, naphthylene ether-based epoxy resins, polyfunctional phenol-based epoxy resins, and naphthalene-based epoxy resins are preferred. By using such another epoxy resin, the flame retardancy and the heat resistance tend to improve more. One of these epoxy resins can be used alone, or two or more of these epoxy resins can be used in combination.

As the maleimide compound, those generally known can be used as long as they are compounds having one or more maleimide groups in one molecule. The type of the maleimide compound is not particularly limited. Specific examples include 4,4-diphenylmethanebismaleimide, phenylmethanemaleimide, m-phenylenebismaleimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, polyphenylmethanemaleimide, novolac-based maleimides, biphenyl aralkyl-based maleimides, and prepolymers of these maleimide compounds or prepolymers of maleimide compounds and amine compounds but are not particularly limited. One of these maleimide compounds can be used, or two or more of these maleimide compounds can be mixed and used. Among these, novolac-based maleimide compounds and biphenyl aralkyl-based maleimide compounds are particularly preferred.

As the phenolic resin, those generally known can be used as long as they are phenolic resins having two or more hydroxyl groups in one molecule. The type of the phenolic resin is not particularly limited. Specific examples of the phenolic resin include bisphenol A-based phenolic resins, bisphenol E-based phenolic resins, bisphenol F-based phenolic resins, bisphenol S-based phenolic resins, phenol novolac resins, bisphenol A novolac-based phenolic resins, glycidyl ester-based phenolic resins, aralkyl novolac-based phenolic resins, biphenyl aralkyl-based phenolic resins, cresol novolac-based phenolic resins, polyfunctional phenolic resins, naphthol resins, naphthol novolac resins, polyfunctional naphthol resins, anthracene-based phenolic resins, naphthalene skeleton-modified novolac-based phenolic resins, phenol aralkyl-based phenolic resins, naphthol aralkyl-based phenolic resins, dicyclopentadiene-based phenolic resins, biphenyl-based phenolic resins, alicyclic phenolic resins, polyol-based phenolic resins, phosphorus-containing phenolic resins, and hydroxyl group-containing silicone resins but are not particularly limited. Among these phenolic resins, biphenyl aralkyl-based phenolic resins, naphthol aralkyl-based phenolic resins, phosphorus-containing phenolic resins, and hydroxyl group-containing silicone resins are preferred in terms of flame retardancy. One of these phenolic resins can be used alone, or two or more of these phenolic resins can be used in combination.

As the oxetane resin, those generally known can be used, and the type of the oxetane resin is not particularly limited. Specific examples of the oxetane resin include oxetane, alkyloxetanes such as 2-methyloxetane, 2,2-dimethyloxetane, 3-methyloxetane, and 3,3-dimethyloxetane, 3-methyl-3-methoxymethyloxetane, 3,3-di(trifluoromethyl)perfluoxetane, 2-chloromethyloxetane, 3,3-bis(chloromethyl)oxetane, biphenyl-based oxetane, OXT-101 (trade name manufactured by Toagosei Co., Ltd.), and OXT-121 (trade name manufactured by Toagosei Co., Ltd.) and however are not particularly limited. One of these oxetane resins can be used alone, or two or more of these oxetane resins can be mixed and used.

As the benzoxazine compound, those generally known can be used as long as they are compounds having two or more dihydrobenzoxazine rings in one molecule. The type of the benzoxazine compound is not particularly limited. Specific examples include bisphenol A-based benzoxazine BA-BXZ (trade name manufactured by Konishi Chemical Ind. Co., Ltd.), bisphenol F-based benzoxazine BF-BXZ (trade name manufactured by Konishi Chemical Ind. Co., Ltd.), and bisphenol S-based benzoxazine BS-BXZ (trade name manufactured by Konishi Chemical Ind. Co., Ltd.) and are not particularly limited. One of these benzoxazine compounds can be used alone, or two or more of these benzoxazine compounds can be mixed and used.

As the compound having a polymerizable unsaturated group, those generally known can be used, and the type of the compound having a polymerizable unsaturated group is not particularly limited. Specific examples of the compound having a polymerizable unsaturated group include vinyl compounds such as ethylene, propylene, styrene, divinylbenzene, and divinylbiphenyl; (meth)acrylates of monohydric or polyhydric alcohols such as methyl (meth)acrylate, 2-hydroxyethyl (meth)acrylate, 2-hydroxypropyl (meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy (meth)acrylates such as bisphenol A-based epoxy (meth)acrylate and bisphenol F-based epoxy (meth)acrylate; benzocyclobutene resins; and (bis)maleimide resins and are not particularly limited. One of these compounds having an unsaturated group can be used alone, or two or more of these compounds having an unsaturated group can be mixed and used.

### [Curing Accelerator]

In addition, the resin composition in this embodiment may contain a curing accelerator for appropriately adjusting the curing rate, as needed. As this curing accelerator, those generally used as curing accelerators for cyanate compounds, epoxy resins, and the like can be preferably used, and the type of the curing accelerator is not particularly limited. Specific examples thereof include organometallic salts such as zinc octylate, zinc naphthenate, cobalt naphthenate, copper naphthenate, acetylacetone iron, nickel octylate, and manganese octylate; phenol compounds such as phenol, xylenol, cresol, resorcin, catechol, octyl phenol, and nonyl phenol; alcohols such as 1-butanol and 2-ethylhexanol; imidazoles such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole and derivatives such as adducts of carboxylic acids of these imidazoles or acid anhydrides thereof; amines such as dicyandiamide, benzyldimethylamine, and 4-methyl-N,N-dimethylbenzylamine; phosphorus compounds such as phosphine-based compounds, phosphine oxide-based compounds, phosphonium salt-based compounds, and diphosphine-based compounds, peroxides such as epoxy-imidazole adduct-based compounds, benzoyl peroxide, p-chlorobenzoyl peroxide, di-t-butyl peroxide, diisopropyl peroxycarbonate, and di-2-ethylhexyl peroxycarbonate; or azo compounds such as azobisisobutyronitrile. One of these curing accelerators can be used alone, or two or more of these curing accelerators can be used in combination.

The content of the curing accelerator can be appropriately adjusted considering the degrees of cure of the resins, the viscosity of the resin composition, and the like and is not particularly limited but is usually preferably 0.005 to 10 parts by mass based on 100 parts by mass of the resin solids in the resin composition.

Further, various polymer compounds such as another thermosetting resin, a thermoplastic resin and an oligomer thereof, and an elastomer, a flame-retardant compound, various additives, and the like can be used in combination in the resin composition in this embodiment as needed. These are not particularly limited as long as they are those generally used. Examples of the flame-retardant compound include bromine compounds such as 4,4'-dibromobiphenyl, phosphates, melamine phosphate, phosphorus-containing epoxy resins, nitrogen compounds such as melamine and benzoguanamine, oxazine ring-containing compounds, and silicone-based compounds. In addition, examples of the various additives include ultraviolet absorbing agents, antioxidants, photopolymerization initiators, fluorescent brightening agents, photosensitizers, dyes, pigments, thickening agents, flow-adjusting agents, lubricants, defoaming agents, dispersing agents, leveling agents, brightening agents, and polymerization inhibitors. One of these can be used alone or two or more of these can be used in combination as desired.

An organic solvent can be used in the resin composition in this embodiment as needed. In this case, the resin composition in this embodiment can be used as a form (solution or varnish) in which at least some, preferably all, of the above-described various resin components are dissolved in or compatible with the organic solvent. As the organic solvent, known ones can be appropriately used as long as they can dissolve or be compatible with at least some, preferably all, of the above-described various resin components. The type of the organic solvent is not particularly limited. Specific examples include polar solvents such as ketones such as acetone, methyl ethyl ketone, and methyl isobutyl ketone; cellosolve-based solvents such as propylene glycol monomethyl ether and propylene glycol monomethyl ether acetate; ester-based solvents such as ethyl lactate, methyl acetate, ethyl acetate, butyl acetate, isoamyl acetate, methyl methoxypropionate, and methyl hydroxyisobutyrate; and amides such as dimethylacetamide and dimethylformamide; and nonpolar solvents such as aromatic hydrocarbons such as toluene and xylene. One of these can be used alone, or two or more of these can be used in combination.

### [Method for Producing Resin Composition]

The resin composition in this embodiment can be prepared according to an ordinary method, and the method for adjusting the resin composition in this embodiment is not particularly limited as long as it is a method in which a resin composition uniformly containing the cyanate compound (A) and the epoxy resin (B) and the above-described other optional components is obtained. For example, the resin composition in this embodiment can be easily prepared by sequentially blending the cyanate compound (A) and the epoxy resin (B) with a solvent and sufficiently stirring the blend.

During preparation of the resin composition, known treatment (stirring, mixing, and kneading treatment and the like) for uniformly dissolving or dispersing the components can be performed. For example, in uniform dispersion of the filler (C), by performing stirring and dispersion treatment using a stirring vessel provided with a stirrer having suitable stirring ability, the dispersibility in the resin composition is increased. The above stirring, mixing, and kneading treatment can be appropriately performed, for example, using a known apparatus such as an apparatus intended for mixing such as a ball mill or a bead mill, or a revolution-rotation mixing apparatus.

### [Applications]

The resin composition in this embodiment can be used as a prepreg, a metal foil-clad laminate, a resin sheet, an insulating layer of a printed wiring board, and a semiconductor package material. These applications will be described below.

### [Prepreg]

A prepreg in this embodiment comprises a base material; and the above resin composition with which the base material is impregnated or coated. The method for producing the prepreg is not particularly limited as long as it is a method of combining the resin composition in this embodiment and a base material to produce a prepreg. Specifically, the prepreg in this embodiment can be produced by impregnating or coating a base material with the resin composition in this embodiment and then semi-curing the resin composition by a method of drying at 120 to 220°C for about 2 to 15 minutes, or the like. At this time, the amount of the resin composition adhered to the base material, that is, the amount of the resin composition (including the filler (C)) based on the total amount of the prepreg after the semi-curing, is preferably in the range of 20 to 99% by mass.

As the base material used when the prepreg in this embodiment is produced, known ones used for various printed wiring board materials can be used. Examples of the base material include, but are not particularly limited to, woven fabrics of fibers of glass such as E glass, D glass, L glass, S glass, T glass, Q glass, UN glass, NE glass, and spherical glass; inorganic fibers of materials other than glass, such as quartz; organic fibers of polyimides, polyamides, polyesters, and the like; liquid crystal polyesters; and the like. As the shape of the base material, woven fabrics, nonwoven fabrics, rovings, chopped strand mats, surfacing mats, and the like are known, and the shape of the base material may be any. One of these base materials can be used alone, or two or more of these materials can be used in combination. In addition, the thickness of the base material is not particularly limited, but is preferably in the range of 0.01 to 0.2 mm in laminate applications. Particularly, woven fabrics subjected to ultra-opening treatment or clogging treatment are preferred from the viewpoint of dimensional stability. Further, glass woven fabrics surface-treated with silane coupling agents for epoxysilane treatment, aminosilane treatment, and the like are preferred from the viewpoint of moisture absorption heat resistance. In addition, liquid crystal polyester woven fabrics are preferred in terms of electrical characteristics.

### [Metal Foil-Clad Laminate]

In addition, a metal foil-clad laminate in this embodiment comprises at least one or more of the above prepregs stacked; and the metal foil disposed on one surface or both surfaces of the prepreg. Examples of the method for producing the metal foil-clad laminate include a method of fabricating the metal foil-clad laminate by stacking one or a plurality of the above-described prepregs, disposing foil of a metal such as copper or aluminum on one surface or both surfaces of the stack, and laminate-molding the metal foil and the stack.

The metal foil used here is not particularly limited as long as it is one used for a printed wiring board material. Copper foil such as rolled copper foil and electrolytic copper foil is preferred. In addition, the thickness of the metal foil is not particularly limited but is preferably 2 to 70 µm, more preferably 3 to 35 µm.

As the molding conditions, usual methods for laminates and multilayer boards for printed wiring boards can be applied. For example, the metal foil-clad laminate in this embodiment can be produced by laminate-molding with a temperature of 180 to 350°C, a heating time of 100 to 300 minutes, and a surface pressure of 20 to 100 kg/cm² using a multistage press, a multistage vacuum press, a continuous molding machine, an autoclave molding machine, or the like. In addition, a multilayer board can also be provided by laminate-molding the above prepreg and a separately fabricated wiring board for an inner layer in combination. As the method for producing a multilayer board, for example, a multilayer board can be fabricated by disposing 35 µm copper foil on both surfaces of one of the above-described prepreg, laminating and forming the copper foil and the prepreg under the above conditions, then forming inner layer circuits, subjecting these circuits to blackening treatment to form an inner layer circuit board, then alternately disposing these inner layer circuit boards and the above prepregs one by one, further disposing copper foil on the outermost layers, and laminate-molding the copper foil, the inner layer circuit boards, and the prepregs under the above conditions preferably under vacuum. The metal foil-clad laminate in this embodiment can be preferably used as a printed wiring board.

### [Printed Wiring Board]

A printed wiring board in this embodiment comprises an insulating layer; and a conductor layer formed on a surface of the insulating layer, and the above insulating layer comprises the above resin composition. The printed wiring board can be produced according to an ordinary method, and the method for producing the printed wiring board is not particularly limited. One example of a method for producing a printed wiring board will be shown below. First, a metal foil-clad laminate such as the above-described copper-clad laminate is provided. Next, the surfaces of the metal foil-clad laminate are subjected to etching treatment to form inner layer circuits to fabricate an inner layer board. The inner layer circuit surfaces of this inner layer board are subjected to surface treatment for increasing adhesive strength, as needed. Then, the required number of the above-described prepregs are stacked on the inner layer circuit surfaces, the metal foil for outer layer circuits is further laminated on the outside of the stack, and heat and pressure are applied for integral molding. In this manner, a multilayer laminate in which insulating layers comprising a base material and a cured product of a thermosetting resin composition are formed between inner layer circuits and the metal foil for outer layer circuits is produced. Then, this multilayer laminate is subjected to perforation for through holes and via holes, and then plating metal films that allow conduction between the inner layer circuits and the metal foil for outer layer circuits are formed on the wall surfaces of these holes. Further, the metal foil for outer layer circuits is subjected to etching treatment to form outer layer circuits. Thus, a printed wiring board is produced.

The printed wiring board obtained in the above production example has a configuration in which it has insulating layers and conductor layers formed on surfaces of these insulating layers, and the insulating layers comprise the resin composition in this embodiment described above. In other words, the prepreg in this embodiment described above (the base material and the resin composition in this embodiment with which the base material is impregnated or coated) and the resin composition layer of the metal foil-clad laminate in this embodiment described above (the layer comprising the resin composition in this embodiment) are composed of an insulating layer comprising the resin composition in this embodiment.

### [Resin Sheet]

A resin sheet in this embodiment comprises a support; and the above resin composition with which a surface of the support is coated and dried. The resin sheet can be obtained by coating a support with a solution of the above resin composition in this embodiment dissolved in a solvent and drying the solution. The resin sheet can be used as a buildup film or a dry film solder resist.

Examples of the support used here include organic film base materials such as polyethylene films, polypropylene films, polycarbonate films, polyethylene terephthalate films, ethylene-tetrafluoroethylene copolymer films, and release films obtained by coating surfaces of these films with release agents, and polyimide films; conductor foil such as copper foil and aluminum foil; and plate-shaped supports such as glass plates, SUS plates, and FRP but are not particularly limited.

Examples of the method for coating with the resin composition include a method of coating a support with a solution of the resin composition in this embodiment dissolved in a solvent by a bar coater, a die coater, a doctor blade, a baker applicator, or the like. In addition, a single-layer sheet (resin sheet) can also be provided by peeling or etching the support from the laminated sheet after drying. A single-layer sheet (resin sheet) can also be obtained without using a support by supplying a solution of the above resin composition in this embodiment dissolved in a solvent into a mold having a sheet-shaped cavity, and drying the solution, or the like for molding into a sheet shape.

In fabrication of the single-layer or laminated sheet in this embodiment, the drying conditions when the solvent is removed are not particularly limited but are preferably a temperature of 20°C to 200°C for 1 to 90 minutes because at low temperature, the solvent is likely to remain in the resin composition, and at high temperature, curing of the resin composition proceeds. In addition, the thickness of the resin layer of the single-layer or laminated sheet in this embodiment can be adjusted by the concentration and coating thickness of the solution of the resin composition in this embodiment and is not particularly limited but is preferably 0.1 to 500 µm because generally, when the coating thickness increases, the solvent is likely to remain during drying. In addition, the resin composition can also be used in an uncured state in which the solvent is only dried, or in a semi-cured (B-staged) state as needed.

### Examples

The present invention will be described in more detail below by showing Synthesis Examples, an Example, and a Comparative Example, but the present invention is not limited to these.

### (Synthesis Example 1) Synthesis of Cyanate Compound

300 g (1.28 mol in terms of OH groups) of a 1-naphthol aralkyl resin (manufactured by NIPPON STEEL & SUMIKIN CHEMICAL CO., LTD.) and 194.6 g (1.92 mol) (1.5 mol based on 1 mol of hydroxy groups) of triethylamine were dissolved in 1800 g of dichloromethane, and this solution was a solution 1.

On the other hand, 125.9 g (2.05 mol) (1.6 mol based on 1 mol of hydroxy groups) of cyanogen chloride, 293.8 g of dichloromethane, 194.5 g (1.92 mol) (1.5 mol based on 1 mol of hydroxy groups) of 36% hydrochloric acid, and 1205.9 g of water were mixed to provide a solution 2. While the solution 2 was kept at a liquid temperature of -2 to -0.5°C under stirring, the solution 1 was poured into the solution 2 over 30 minutes. After completion of pouring of the solution 1, the mixture was stirred at the same temperature for 30 minutes, and then a solution of 65 g (0.64 mol) (0.5 mol based on 1 mol of hydroxy groups) of triethylamine dissolved in 65 g of dichloromethane (solution 3) was poured into the solution 2 over 10 minutes. After completion of pouring of the solution 3, the mixture was stirred at the same temperature for 30 minutes to complete the reaction.

Then, the reaction liquid was allowed to stand to separate the organic phase and the aqueous phase. The obtained organic phase was washed five times with 1300 g of water. The electrical conductivity of the wastewater from the fifth water washing was 5 µS/cm, and it was confirmed that removable ionic compounds were sufficiently removed by the washing with water.

The organic phase after the water washing was concentrated under a reduced pressure and finally concentrated to dryness at 90°C for 1 hour to obtain 331 g of the target naphthol aralkyl-based cyanate compound (SNCN) (orange viscous material). The mass average molecular weight Mw of the obtained SNCN was 600. In addition, the IR spectrum of SNCN showed absorption at 2250 cm⁻¹ (cyanate groups) and showed no absorption of hydroxy groups.

### (Example 1)

50 parts by mass of the SNCN obtained by Synthesis Example 1, 50 parts by mass of an epoxy resin having at least one or more structural units represented by the following formula (1) and the following formula (2) (NC-3500, manufactured by Nippon Kayaku Co., Ltd.), 100 parts by mass of fused silica (SC2050MB, manufactured by Admatechs Company Limited), and 0.15 parts by mass of zinc octylate (manufactured by Nihon Kagaku Sangyo Co., Ltd.) were mixed to obtain a varnish. This varnish was diluted with methyl ethyl ketone, and an E-glass woven fabric having a thickness of 0.1 mm was impregnated and coated with the diluted varnish and heated and dried at 150°C for 5 minutes to obtain a prepreg having a resin content of 50% by mass. The molar ratio of the structural unit represented by formula (2) to 10 mol of the structural unit represented by formula (1) was in the range of about 1 to 3.

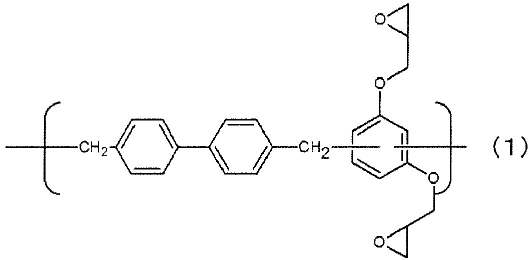

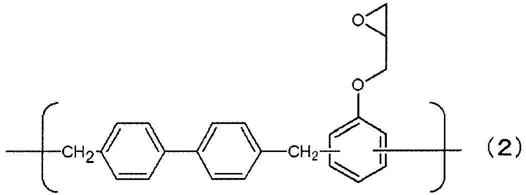

Eight of the obtained prepregs were stacked, and 12 µm thick electrolytic copper foil (3EC-M3-VLP, manufactured by MITSUI MINING & SMELTING CO., LTD.) was disposed on the top and the bottom. The stack was laminate-molded at a pressure of 30 kgf/cm² and a temperature of 220°C for 120 minutes to obtain a metal foil-clad laminate having an insulating layer thickness of 0.8 mm. Evaluation of glass transition temperature (Tg) was performed using the obtained metal foil-clad laminate. The result is shown in Table 1.

### (Comparative Example 1)

A metal foil-clad laminate having a thickness of 0.8 mm was obtained as in Example 1 except that 50 parts by mass of a biphenyl aralkyl-based epoxy resin having only the structural unit represented by formula (2) (NC-3000-FH, manufactured by Nippon Kayaku Co., Ltd.) was used instead of using 50 parts by mass of the epoxy resin having at least one or more structural units represented by formula (1) and formula (2), and the amount of zinc octylate used was 0.12 parts by mass. The evaluation result of the obtained metal foil-clad laminate is shown in Table 1.

### (Measurement Method and Evaluation Method)

Glass transition temperature: Each of the metal foil-clad laminates obtained in Example 1 and Comparative Example 1 was cut to a size of 40 mm × 20 mm, and the glass transition temperature was measured by a dynamic viscoelasticity measuring apparatus (manufactured by TA Instruments) in accordance with JIS C6481.

**[Table 1]**

| | | Example 1 | Comparative Example 1 |
|---|---|---|---|
| Glass transition temperature | (°C) | 276 | 250 |

As is clear from Table 1, it was confirmed that by using the resin composition of the present invention, a prepreg, a printed wiring board, and the like having excellent glass transition temperature were realized.

This application is based on Japanese Patent Application No. 2015-086409 filed with the Japan Patent Office on April 21, 2015, the contents of which are incorporated herein by reference.

### Industrial Applicability

As described above, the resin composition of the present invention can be widely and effectively used in various applications such as electrical and electronic materials, machine tool materials, and aviation materials, for example, as electrical insulating materials, semiconductor plastic packages, sealing materials, adhesives, lamination materials, resists, and buildup laminate materials, and, particularly, can be especially effectively used as printed wiring board materials adapted to higher integration and higher density for information terminal equipment, communication equipment, and the like in recent years. In addition, the laminate, metal foil-clad laminate, and the like of the present invention have performance also excellent in glass transition temperature, and therefore their industrial practicality is extremely high.

## Claims

1. A resin composition comprising:
a cyanate compound (A); and
an epoxy resin (B) having a structural unit represented by the following formula (1) and a structural unit represented by the following formula (2).

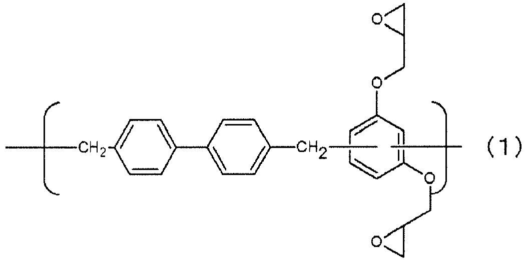

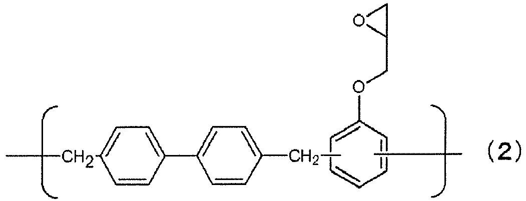

2. The resin composition according to claim 1, wherein a content of the epoxy resin (B) is 1 to 90 parts by mass based on 100 parts by mass of resin solids in the resin composition.

3. The resin composition according to claim 1 or 2, further comprising a filler (C).

4. The resin composition according to any one of claims 1 to 3, further comprising any one or more selected from the group consisting of an epoxy resin other than the epoxy resin (B), a maleimide compound, a phenolic resin, an oxetane resin, a benzoxazine compound, and a compound having a polymerizable unsaturated group.

5. The resin composition according to claim 3 or 4, wherein a content of the filler (C) is 50 to 1600 parts by mass based on 100 parts by mass of the resin solids in the resin composition.

6. A prepreg comprising:
a base material; and
the resin composition according to any one of claims 1 to 5 with which the material is impregnated or coated.

7. A metal foil-clad laminate comprising:
at least one or more of the prepregs according to claim 6 stacked; and
a metal foil disposed on one surface or both surfaces of the prepreg.

8. A resin sheet comprising:
a support; and
the resin composition according to any one of claims 1 to 5 with which a surface of the support is coated and dried.

9. A printed wiring board comprising:
an insulating layer; and
a conductor layer formed on a surface of the insulating layer, wherein
the insulating layer comprises the resin composition according to any one of claims 1 to 5.

## Patentansprüche

1. Harzzusammensetzung, umfassend:
eine Cyanatverbindung (A) und
ein Epoxidharz (B) mit einer durch die folgende Formel (1) dargestellten Struktureinheit und einer durch die folgende Formel (2) dargestellten Struktureinheit

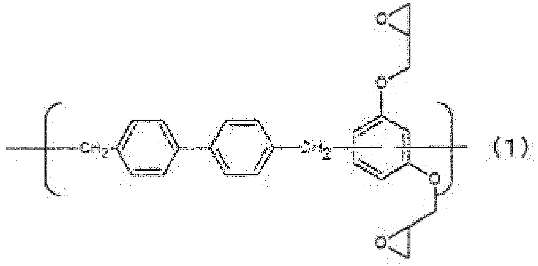

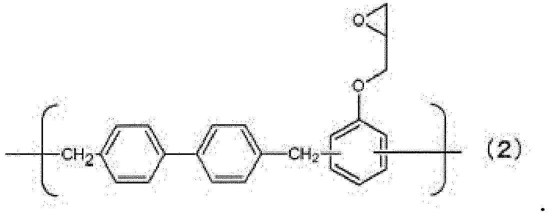

2. Harzzusammensetzung gemäß Anspruch 1, wobei ein Gehalt des Epoxidharzes (B) 1 bis 90 Masseteile, bezogen auf 100 Masseteile der Harzfeststoffe in der Harzzusammensetzung, beträgt.

3. Harzzusammensetzung gemäß Anspruch 1 oder 2, ferner umfassend einen Füllstoff (C).

4. Harzzusammensetzung gemäß irgendeinem der Ansprüche 1 bis 3, ferner umfassend mindestens eines/eine, ausgewählt aus der Gruppe, bestehend aus einem von dem Epoxidharz (B) verschiedenen Epoxidharz, einer Maleimidverbindung, einem Phenolharz, einem Oxetanharz, einer Benzoxazinverbindung und einer Verbindung mit einer polymerisierbaren ungesättigten Gruppe.

5. Harzzusammensetzung gemäß Anspruch 3 oder 4, worin ein Gehalt des Füllstoffs (C) 50 bis 1.600 Masseteile, bezogen auf 100 Masseteile der Harzfeststoffe in der Harzzusammensetzung, beträgt.

6. Prepreg, umfassend:
ein Basismaterial und
die Harzzusammensetzung gemäß irgendeinem der Ansprüche 1 bis 5, mit der das Material imprägniert oder beschichtet ist.

7. Metallfolien-kaschiertes Laminat, umfassend:
mindestens ein oder mehrere gestapelte Prepregs gemäß Anspruch 6 und
eine Metallfolie, die auf einer Oberfläche oder beiden Oberflächen des Prepregs angeordnet ist.

8. Harzplatte, umfassend:
einen Träger und
die Harzzusammensetzung gemäß irgendeinem der Ansprüche 1 bis 5, mit der eine Oberfläche des Trägers beschichtet und getrocknet ist.

9. Leiterplatte, umfassend:
eine Isolierschicht und
eine Leiterschicht, die auf einer Oberfläche der Isolierschicht gebildet ist, wobei
die Isolierschicht die Harzzusammensetzung gemäß irgendeinem der Ansprüche 1 bis 5 umfasst.

## Revendications

1. Composition de résine comprenant :
un composé cyanate (A) ; et
une résine époxy (B) présentant un motif structural représenté par la formule (1) suivante et un motif structural représenté par la formule (2) suivante.

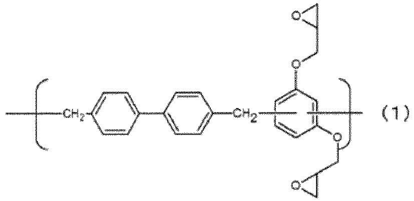

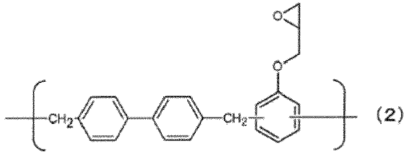

2. Composition de résine selon la revendication 1, dans laquelle une teneur en la résine époxy (B) vaut de 1 à 90 parties en masse par rapport à 100 parties en masse de matières solides de résine dans la composition de résine.

3. Composition de résine selon la revendication 1 ou 2, comprenant encore une charge (C).

4. Composition de résine selon l'une quelconque des revendications 1 à 3, comprenant en outre un(e) quelconque ou plusieurs choisi(e)(s) dans le groupe constitué par une résine époxy autre que la résine époxy (B), un composé maléimide, une résine phénolique, une résine oxétane, un composé benzoxazine, et un composé présentant un groupe insaturé polymérisable.

5. Composition de résine selon la revendication 3 ou 4, dans laquelle une teneur en la charge (C) vaut de 50 à 1 600 parties en masse sur la base de 100 parties en masse des matières solides de résine dans la composition de résine.

6. Préimprégné comprenant :
un matériau de base ; et
la composition de résine selon l'une quelconque des revendications 1 à 5, avec laquelle le matériau est imprégné ou revêtu.

7. Stratifié revêtu de feuille métallique, comprenant :
au moins un ou plusieurs des préimprégnés selon la revendication 6, empilés ; et
une feuille métallique disposée sur une surface ou les deux surfaces du préimprégné.

8. Feuille de résine comprenant :
un support ; et
la composition de résine selon l'une quelconque des revendication 1 à 5, avec laquelle une surface du support est revêtue et séchée.

9. Carte à circuit imprimé comprenant :
une couche isolante ; et
une couche conductrice formée sur une surface de la couche isolante, dans laquelle
la couche isolante comprend la composition de résine selon l'une quelconque des revendications 1 à 5.
